# EUROPEAN PATENT APPLICATION

(11) **EP 4 266 373 A1**
(43) Date of publication of application: **25.10.2023**
(21) Application number: 21911130.9
(22) Date of filing: 19.01.2021
(51) Int. Cl.: H01L 27/32, H01L 51/00

(54) **DISPLAY DEVICE**

(30) Priority: 21.12.2020 KR 20200179897
(71) Applicant: Unijet Co., Ltd., Seongnam-si, Gyeonggi-do 13203 (KR)
(72) Inventor: KIM, Seog-soon, Seongnam-si Gyeonggi-do 13203 (KR)
(74) Representative: Krauns, Christian
(86) International application number: PCT/KR2021/000740
(87) International publication number: WO 2022/139060

(57) **Abstract**

The present invention relates to a display apparatus having improved resolution by realizing a pixel as a rectangular structure in order to perform four-times greater high resolution pixel printing within a limit of an accuracy and a size of a currently existing ink drop.

To this end, a display apparatus according the present invention includes: a first light emitting group including four first sub-pixels contained in different pixels to emit the same color light; a second light emitting group including four second sub-pixels contained in different pixels to emit the same color light; a third light emitting group including four third sub-pixels contained in different pixels to emit the same color light; and a fourth light emitting group including four fourth sub-pixels contained in different pixels to emit the same color light, and four of the first sub-pixel, the second sub-pixel, the third sub-pixel, and the fourth sub-pixel, which are disposed closest to each other, form one pixel.

## Description

### TECHNICAL FIELD

The present invention relates to a display apparatus, and more particularly, to a display apparatus having improved resolution.

### BACKGROUND ART

A display apparatus is an apparatus for displaying an image, and an organic light emitting display apparatus is recently spotlighted.

The organic light emitting display apparatus includes a plurality of pixels each including a cathode, an anode, and an organic light emitting device (OLED) including an organic emission material layer, and a plurality of transistors and a capacitor, which are for driving the organic light emitting device, are formed in each pixel. The plurality of transistors basically includes a switching transistor and a driving transistor. Also, a thin-film encapsulation layer in which inorganic layers and organic layers are mixed to protect the organic light emitting layer from moisture and oxygen is formed on the cathode.

This organic light emitting display apparatus has an advantage of having a self-light emitting characteristic and not requiring a separate light source unlike a liquid crystal display device and exhibits a high quality characteristic such as low power consumption, high brightness, and high reaction speed.

In general, the organic light emitting display apparatus includes a plurality of pixels each emitting different color light, and the plurality of pixels emit light to display an image.

Here, the pixel may represent a minimum unit for displaying an image, and a gate line for driving each pixel, a data line, a power line such as a driving power line, and an insulation layer such as a pixel defining layer for defining an area or a shape of each pixel may be disposed between neighboring pixels.

An organic emission material layer constituting the pixel of the typical organic light emitting display apparatus is formed through deposition using a mask such as a fine metal mask (FMM). When a gap between the neighboring pixels decreases to secure an opening rate of the pixel, deposition reliability is degraded, and when the gap between the pixels increases to improve the deposition reliability, the opening rate of the pixel is degraded.

In order to overcome the above-described limitation, an inkjet printing technology is used for manufacturing the organic light emitting display apparatus.

For example, the inkjet printing technology is used in a manufacturing field of a color filter (CF) for LCD, a manufacturing field of a hole injection layers (HIL), a hole transporting layer (HTL), and a RGB emission material layer (EML), and a manufacturing field of a hole injection layer (HIL), an interlayer (IL), and a polymer RGB emission material layer in a polymer OLED.

Currently, RGB pixel printing using the inkjet printing technology is mainly developed and applied for printing a QD color conversion (QDCC) layer or a color filter for large-sized TV of 300 pixels per inch or less that is mass-producible, and a polymer OLED printing technology is applied for manufacturing a medium-sized display apparatus or 4K monitor of 300 PPI or less.

Currently, the RGB pixel printing using perovskite ink developed for selfemission or color conversion, phosphor ink, and inks including blue, red, and green nano-LEDs may be applied.

As described above, the biggest reason why the current inkjet printing technology is applied to only the display apparatus of 300 PPI or less is because the RGB inkjet printing is performed within a range capable of stably performing mass-production in consideration of substantial printing accuracy of ink drops considering pixel sizes, sizes of ink drops, tolerances of equipment, and a printing accuracy of a head.

Specifically, the inkjet printing technology may not reduce a size of the ink drop discharged from an inkjet head less than 0.5 pl (a diameter of 9.85 µm) and thus may not apply the ink drop to a pixel smaller than the ink drop.

Also, printing is substantially inevitably performed on the pixel bigger in size than the ink drop in consideration of accuracy error of the ink drop due to various accuracy errors such as meandering, speed errors, accuracy errors of equipment, alignment errors of substrates generated when the ink drop is discharged.

Due to this limitation, substantial resolution of the display apparatus realized by the inkjet method may have theoretical maximum of 800 PPI and substantial maximum of 500 PPI.

However, as high speed 5G communication is available, the current display apparatus for mobile phones having a maximum resolution of 577 PPI (3K) is required to have further higher resolution of the level of 800 PPI (4K), and the display apparatus applied to glasses for virtual reality (VR), augmented reality (AR), mixed reality (MR), and extended reality (XR), which are developed and expected to replace the mobile phones in the near future, requires a super-resolution of 2000 PPI or more.

### [Related art document]

Korean Patent Publication No. 10-2020-0133095 (November 26, 2020)

### DISCLOSURE OF THE INVENTION

### TECHNICAL PROBLEM

The purpose of the present invention to resolve the problem of the related art is to provide a display apparatus having improved resolution by realizing a pixel as a rectangular structure in order to perform four-times greater high resolution pixel printing within a limit of an accuracy and a size of a currently existing ink drop.

### TECHNICAL SOLUTION

A display apparatus according to an embodiment of the present invention for resolving the above technical problem includes: a first light emitting group including four first sub-pixels contained in different pixels to emit the same color light; a second light emitting group including four second sub-pixels contained in different pixels to emit the same color light; a third light emitting group including four third sub-pixels contained in different pixels to emit the same color light; and a fourth light emitting group including four fourth sub-pixels contained in different pixels to emit the same color light, and four of the first sub-pixel, the second sub-pixel, the third sub-pixel, and the fourth sub-pixel, which are disposed closest to each other, form one pixel.

In an embodiment, each of the first to fourth light emitting groups may be formed in plurality and arranged in a matrix form on a thin-film transistor substrate along a first direction and a second direction crossing the first direction, and the number of each of the first to fourth light emitting groups may be equal to each other.

In an embodiment, the first to fourth light emitting groups may be spaced by the same gap from each other, centers of two neighboring light emitting groups among the first to fourth light emitting groups may be spaced by a first distance, and the closest same light emitting groups may be spaced by a second distance that is two times of the first distance.

In an embodiment, the first to fourth sub-pixels constituting the one pixel may be arranged in a rectangular shape.

In an embodiment, each of the first to fourth sub-pixels may have a central angle of 90°, and a corner formed with an angle of 90° or less may be processed to be rounded with the larger than 90°.

In an embodiment, each of the first to fourth light emitting groups may emit one color light of red, green, blue, and white light, and the first to fourth light emitting groups may emit different color light.

In an embodiment, each of the first to fourth light emitting groups may emit one color light of red, green, blue, and white light, and two light emitting groups among the first to fourth light emitting groups may emit the same color light.

In an embodiment, the two light emitting groups emitting the same color light may be electrically connected with the same thin-film transistor and simultaneously controlled.

In an embodiment, the two light emitting groups emitting the same color light may be electrically connected with different thin-film transistors and individually controlled.

In an embodiment, the two light emitting groups emitting the same color light may emit blue light, one light emitting group of the rest may emit red light, and the other light emitting group of the rest may emit green light.

In an embodiment, the two light emitting groups emitting the same color light may emit green light, one light emitting group of the rest may emit red light, and the other light emitting group of the rest may emit blue light.

In an embodiment, the two light emitting groups emitting the same color light may emit red light, one light emitting group of the rest may emit green light, and the other light emitting group of the rest may emit blue light.

In an embodiment, each of the first to fourth light emitting groups may include: four pixel electrodes corresponding to four sub-pixels, respectively; four light emitting layers laminated on the four pixel electrodes, respectively; and four opposite electrodes laminated on the four light emitting layers, respectively.

In an embodiment, each of the first to fourth light emitting groups may include: four pixel electrodes corresponding to four sub-pixels, respectively; one light emitting layer overlapping all of the four pixel electrodes; and four opposite electrodes laminated on the light emitting layer in correspondence to the four pixel electrodes, respectively.

In an embodiment, each of a light emitting layer formed in the first light emitting group, a light emitting layer formed in the second light emitting group, a light emitting layer formed in the third light emitting group, and a light emitting layer formed in the fourth light emitting group may be formed with a different ink by inkjet printing.

In an embodiment, a light emitting layer formed in the first light emitting group, a light emitting layer formed in the second light emitting group, a light emitting layer formed in the third light emitting group, and a light emitting layer formed in the fourth light emitting group may be formed by inkjet printing, and at least two light emitting layers of the light emitting layer formed in the first light emitting group, the light emitting layer formed in the second light emitting group, the light emitting layer formed in the third light emitting group, and the light emitting layer formed in the fourth light emitting group may be formed with the same ink by the inkjet printing.

In an embodiment, at least one light emitting group of the first light emitting group, the second light emitting group, the third light emitting group, and the fourth light emitting group may have a different size.

In an embodiment, the two light emitting groups emitting the same color light may be arranged on a thin-film transistor substrate in one row along a first direction or a second direction crossing the first direction.

### ADVANTAGEOUS EFFECTS

The above-described present invention has an advantage capable of performing the pixel printing having the four-times greater high resolution with the size and accuracy of the currently existing ink drop and, through this, the resolution from at least 2000 PPI upto 2400 PPI may be realized by the current inkjet technology. That is, the high resolution display apparatus such as 4K mobile phones, AR, VR, MA, and XR may be manufactured by the inkjet method.

Also, as the pixel is realized as the rectangular structure, the central angle of the sub-pixel may form 90° to form the structure in which all corners in the sub-pixel do not have the acute angle, as each corner is processed to be rounded, the printing quality of the inkjet ink may be enhanced, and the loss of the opening rate may be minimized, and as the light having the wider color is emitted from the same area, the brightness of the display apparatus may improve.

Also, as the four-times greater high resolution is achieved with the less number of pixels in comparison with the competitive technology, the structure of the thin-film transistor may be simplified.

Also, since the micro-OLED without the color filter may be realized by performing the RGB pixel printing having the four-times greater high resolution, further greater optical efficiency than the typical color filter method may be obtained.

Also, even the OLED for TV having the low resolution may easily obtain the high resolution, and particularly, when the various sized display apparatuses are manufactured in the mother glass by a multi model glass (MMG) method during manufacturing the high resolution TV, the display apparatus having the pixel arrangement in different directions may be manufactured without rotating the glass.

The object of the present invention is not limited to the aforesaid, but other objects not described herein will be clearly understood by those skilled in the art from descriptions below.

### BRIEF DESCRIPTION OF THE DRAWINGS

FIG. 1 is a plan view of a display apparatus according to an embodiment of the present invention.
FIG. 2 is a plan view illustrating a portion of a pixel arrangement of a display apparatus according to a first embodiment of the present invention.
FIG. 3 is a plan view illustrating a portion of a pixel arrangement of a display apparatus according to a second embodiment of the present invention.
FIG. 4 is a plan view illustrating a portion of a pixel arrangement of a display apparatus according to a third embodiment of the present invention.
FIG. 5 is a plan view illustrating a portion of a pixel arrangement of a display apparatus according to a fourth embodiment of the present invention.
FIG. 6 is a plan view illustrating a portion of a pixel arrangement of a display apparatus according to a fifth embodiment of the present invention.
FIG. 7 is a plan view illustrating a portion of a pixel arrangement of a display apparatus according to a sixth embodiment of the present invention.
FIG. 8 is a plan view illustrating a portion of a pixel arrangement of a display apparatus according to a seventh embodiment of the present invention.
FIG. 9 is a plan view illustrating a first sub-pixel constituting a first light emitting group of the display apparatus according to the first embodiment of the present invention.
FIG. 10 is a cross-sectional view corresponding to the first light emitting group of the display apparatus according to the first embodiment of the present invention.
FIG. 11 is a schematic view illustrating a structure of a polymer OLED.
FIG. 12 is a schematic view illustrating a process of manufacturing a RGB polymer OLED using an inkjet printing method.

### MODE FOR CARRYING OUT THE INVENTION

The present invention may be carried out in various embodiments without departing from the technical ideas or primary features. Therefore, the embodiments of the present invention are merely illustrative, but should not be limitedly interpreted.

It will be understood that although the terms of first and second are used herein to describe various elements, these elements should not be limited by these terms.

The terms are only used to distinguish one component from other components. For example, a first element referred to as a first element in one embodiment can be referred to as a second element in another embodiment.

As used herein, the term and/or includes any and all combinations of one or more of the associated listed items.

It will also be understood that when an element is referred to as being "'connected to" or "engaged with" another element, it can be directly connected to the other element, or intervening elements may also be present.

It will also be understood that when an element is referred to as being 'directly connected to' another element, there is no intervening elements.

In the following description, the technical terms are used only for explaining a specific exemplary embodiment while not limiting the present invention. The terms of a singular form may include plural forms unless referred to the contrary.

The meaning of `include' or 'comprise' specifies a property, a number, a step, a process, an element, a component, or a combination thereof in the specification but does not exclude other properties, numbers, steps, processes, elements, components, or combinations thereof.

Unless terms used in the present disclosure are defined differently, the terms may be construed as meaning known to those skilled in the art.

Terms such as terms that are generally used and have been in dictionaries should be construed as having meanings matched with contextual meanings in the art. In this description, unless defined clearly, terms are not ideally, excessively construed as formal meanings.

Hereinafter, embodiments disclosed in this specification is described with reference to the accompanying drawings, and the same or corresponding components are given with the same drawing number regardless of reference number, and their duplicated description will be omitted.

Moreover, detailed descriptions related to well-known functions or configurations will be ruled out in order not to unnecessarily obscure subject matters of the present invention.

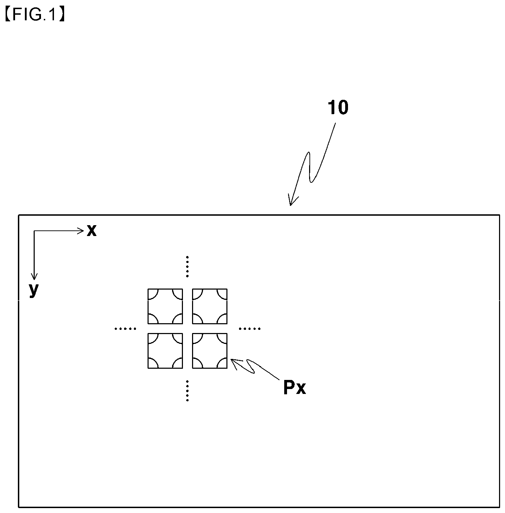

As illustrated in FIG. 1, a display apparatus 10 according to an embodiment of the present invention may include a plurality of pixels Px that are repeatedly arranged in a matrix form in a first direction and a second direction crossing the first direction on a thin-film transistor substrate. The first direction may be a X-axis direction, and the second direction may be a Y-axis direction.

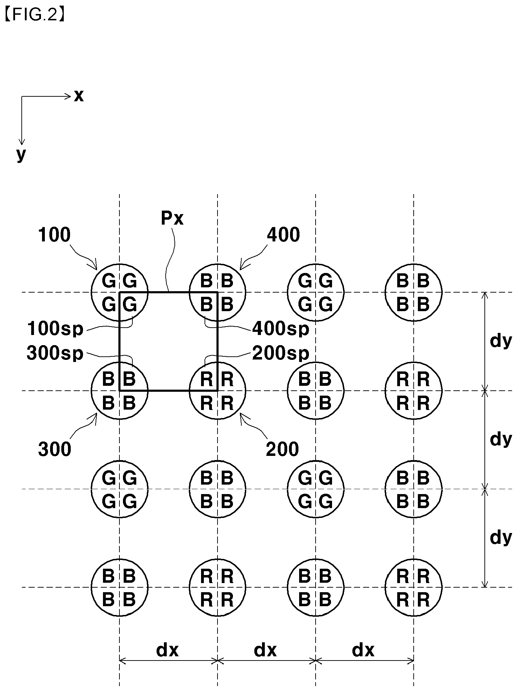

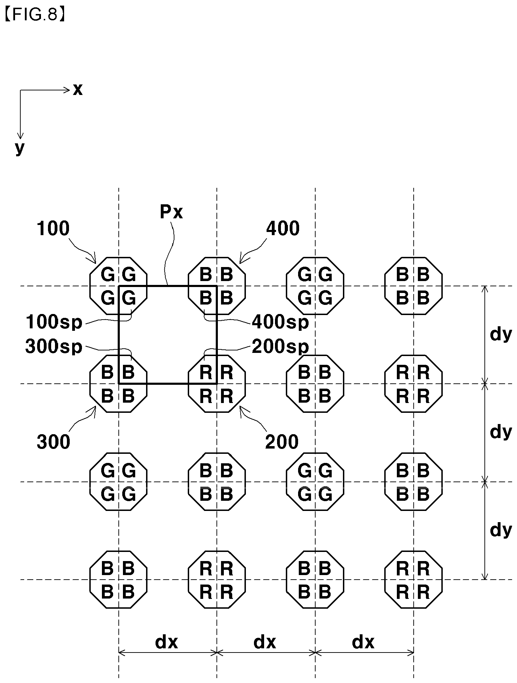

As illustrated in FIGS. 2 to 8, each of the pixels Px may include a first sub-pixel 100sp, a second sub-pixel 200sp a third sub-pixel 300sp, and a fourth sub-pixel 400sp, each of which emits one of red light, green light, blue light, and white light.

In an embodiment of FIG. 2, the first sub-pixel 100sp emits green light, the second sub-pixel 200sp emits red light, and each of the third sub-pixel 300sp and the fourth sub-pixel 400sp emits blue light, and this combination of color light may be variously changed. Various embodiments will be described.

Hereinafter, the display apparatus according to a first embodiment of the present invention will be described with reference to FIG. 2.

As illustrated in FIG. 2, the display apparatus according to the first embodiment includes a first light emitting group 100 including four first sub-pixels 100sp, a second light emitting group 200 including four second sub-pixels 200sp, a third light emitting group 300 including four third sub-pixels 300sp, and a fourth light emitting group 400 including four fourth sub-pixels 400sp.

The four first sub-pixels 100sp constituting the first light emitting group 100 emit the same color light, and the first sub-pixels 100sp are contained in different pixels Px, respectively.

The four second sub-pixels 200sp constituting the second light emitting group 200 emit the same color light, and the second sub-pixels 200sp are contained in different pixels Px, respectively.

The four third sub-pixels 300sp constituting the third light emitting group 300 emit the same color light, and the third sub-pixels 300sp are contained in different pixels Px, respectively.

The four fourth sub-pixels 400sp constituting the fourth light emitting group 400 emit the same color light, and the fourth sub-pixels 400sp are contained in different pixels Px, respectively.

Specifically, as illustrated in FIG. 2, the four first sub-pixels 100sp constituting the first light emitting group 100 constituting the display apparatus according to the first embodiment emit green light, the four second sub-pixels 200sp constituting the second light emitting group 200 emit red light, the four third sub-pixels 300sp constituting the third light emitting group 300 emit blue light, and the four fourth sub-pixels 400sp constituting the fourth light emitting group 400 emit blue light.

Each of the first light emitting group 100, the second light emitting group 200, the third light emitting group 300, and the fourth light emitting group 400 is provided in plurality and repeatedly arranged in a matrix form along the X-axis direction and the Y-axis direction on the thin-film transistor substrate.

The first light emitting group 100, the second light emitting group 200, the third light emitting group 300, and the fourth light emitting group 400 may be spaced by the same distance from each other with respect to the X-axis direction and the Y-axis direction.

The number of each of the first light emitting group 100, the second light emitting group 200, the third light emitting group 300, and the fourth light emitting group 400 per unit area may be equal to each other.

Each of the first light emitting group 100, the second light emitting group 200, the third light emitting group 300, and the fourth light emitting group 400 per unit area may be formed in a circular shape.

With respect to the X-axis direction, a distance between centers of two neighboring light emitting groups among the first light emitting group 100, the second light emitting group 200, the third light emitting group 300, and the fourth light emitting group 400 is spaced by a first distance dx, and a distance between closest same light emitting groups is spaced by a second distance 2dx that is two times of the first distance.

With respect to the Y-axis direction, a distance between centers of two neighboring light emitting groups among the first light emitting group 100, the second light emitting group 200, the third light emitting group 300, and the fourth light emitting group 400 is spaced by a first distance dy, and a distance between closest same light emitting groups is spaced by a second distance 2dy that is two times of the first distance.

Here, the first distance dx in the X-axis direction may be the same distance as the first distance dy in the Y-axis direction.

Four of the first sub-pixel 100sp, the second sub-pixel 200sp, the third sub-pixel 300sp, and the fourth sub-pixel 400sp, which are disposed closest to each other, form one pixel Px by the above-described constitution of the first light emitting group 100, the second light emitting group 200, the third light emitting group 300, and the fourth light emitting group 400.

That is, the first sub-pixel 100sp, the second sub-pixel 200sp, the third sub-pixel 300sp, and the fourth sub-pixel 400sp, which are disposed closest to each other, are arranged in a rectangular shape to form one pixel Px.

Specifically, the one pixel Px is constituted by the first sub-pixel 100sp emitting green light, the second sub-pixel 200sp emitting red light, the third sub-pixel 300sp emitting blue light, and the fourth sub-pixel 400sp emitting blue light, and as all of the third sub-pixel 300sp and the fourth sub-pixel 400sp emit blue light, an area emitting the blue light may be two times of an area emitting the green light or the red light. Through the above constitution, a disadvantage, in which a blue device that is an organic light emitting material emitting blue light having a low efficiency generally has a shorter lifespan than an organic light emitting material emitting different color light, may be compensated.

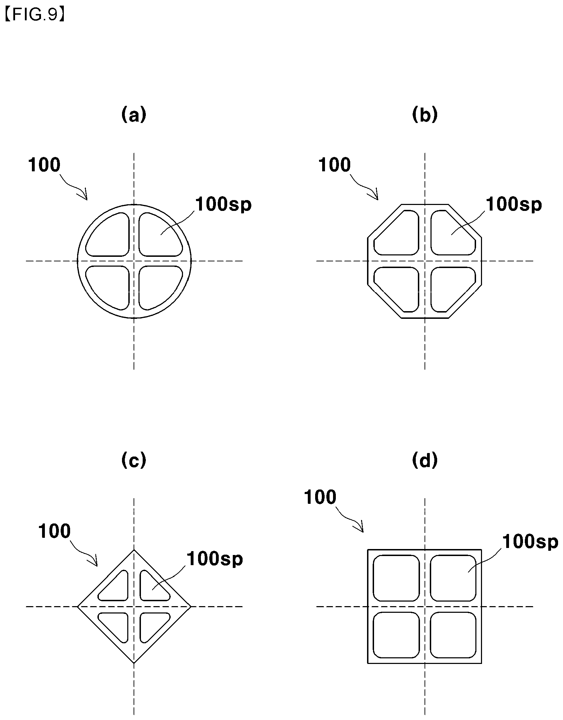

Meanwhile, although a case in which each of the first light emitting group 100, the second light emitting group 200, the third light emitting group 300, and the fourth light emitting group 400 is formed in a circular shape is exemplarily described, each of the first light emitting group 100, the second light emitting group 200, the third light emitting group 300, and the fourth light emitting group 400 may be formed in a polygonal shape in addition to the circular shape as illustrated in FIG. 9.

For example, each of the first light emitting group 100, the second light emitting group 200, the third light emitting group 300, and the fourth light emitting group 400 may be formed in various shapes such as a circular shape of (a), an octagonal shape of (b), a diamond shape of (c), and a square shape of (d) of FIG. 9, and a case in which each of the first light emitting group 100, the second light emitting group 200, the third light emitting group 300, and the fourth light emitting group 400 is formed in the octagonal shape is exemplarily illustrated.

When described with reference to the first light emitting group 100, as the first light emitting group 100 is formed in the octagonal shape, central corners of four first sub-pixels 100sp are formed into a 90°-shape to be advantageous in inkjet ink printing. Also, the octagonal shape may have an advantage in securing a light emitting area greater than that of the circular shape.

Particularly, each of the corners of the first sub-pixel 100SP constituting the first light emitting group 100 may be processed to be rounded.

As described above, each of the corners of the first sub-pixel 100sp is processed to be rounded because ink is hardly filled in a corner gap due to own surface tension of the ink, and also the narrow gap substantially causes a limitation in light emitting characteristic.

In consideration of this point, the diamond shape illustrated in (c) of FIG. 9 may have an area loss increasing at each corner, and the square shape illustrated in (d) may not maintain a sufficient gap with the sub-pixel emitting different color light although the light emitting area is great. Thus, the circular shape of illustrated in (a) of FIG. 9 and the octagonal shape illustrated in (b) are the most preferable shapes capable of maintaining a sufficient gap with the sub-pixel emitting different color light and increasing the light emitting area and the most properly applicable shape in consideration of a substantial OLED opening rate or the like.

A detailed structure of the above-described first sub-pixel 100sp is applied to the second sub-pixel 200sp, the third sub-pixel 300sp, and the fourth sub-pixel 400sp in the same manner.

As described above, a structure for completely and finely filling the inkjet ink to an end of each corner of the first sub-pixel 100sp, the second sub-pixel 200sp, the third sub-pixel 300sp, and the fourth sub-pixel 400sp is formed by the shape in which a central angle of each of the first sub-pixel 100sp, the second sub-pixel 200sp, the third sub-pixel 300sp, and the fourth sub-pixel 400sp forms 90° instead of an acute angle, and each corner is processed to be rounded.

Since the inkjet ink generally has a surface tension of about 30 dyne/cm (the inkjet ink generally has a range from 25 dyne/cm to 35 dyne/cm according to heads), the surface tension of the inkjet ink is somewhat great.

Due to this reason, when an angle of the corner of the sub-pixel is formed as an acute angle shape that is extremely sharp, the inkjet ink may not be completely and finely filled to the end of each corner of the sub-pixel Px although a surface characteristic of a pattern definition layer (PDL) or a surface characteristic of a substrate is hydrophilic processed.

Thus, when printing is performed by filling the ink to each sub-pixel in an inkjet method, the shape of the sub-pixel is extremely important to completely and finely fill the ink to the sub-pixel, and when the central angle of each of the first sub-pixel 100sp, the second sub-pixel 200sp, the third sub-pixel 300sp, and the fourth sub-pixel 400sp according to the first embodiment is 90° instead of the acute angle, the inkjet ink may be completely and finely filled to the end of each corner in consideration of the surface tension characteristic of the inkjet ink.

In more detail, all fluids physically form a shape in a direction in which energy becomes the lowest and also maintain a stable state with respect to a surface state and surrounding atmosphere.

That is, the most stable state of an ink drop may form a spherical shape, and the ink drop may have a semispherical spotted shape having various contact angles according to the surface tension of the ink and surrounding surface energy after spotted on a flat surface.

Thus, the ink drop spotted on the flat surface inevitably has a circular shape with respect to the surface.

In RGB pixel printing, ink drops spotted on a printing area form various shapes according to a shape of the printing area.

For example, when a color filter is printed, since a pixel surface has a high lyophilic property, a surface state in which the ink is filled upto a 90° corner is easily made.

However, in a pixel of an OLED display apparatus, since additional functional layers such as HIL and HTL are required to be formed, a surface state of hardly filling the 90° corner is formed because processing appropriately to the lyophilic property is not easy.

Thus, when the corner having a rounded shape having a predetermined radius is formed instead of forming a rectangular corner, the ink is further easily filled to the rounded corner.

Since a surface of the OLED pixel is not easily formed to have an extremely low lyophilic property like a pixel of the color filter, the filling of the 90° corner is substantially difficult.

Thus, forming and printing a pixel shape having an acute angle less than 90° substantially further hardly fill the pixel, and forming the acute angle into a rounded corner shape loses further greater area to generate a limitation in increasing the opening rate that is important to enhance the OLED characteristic.

Also, the reason why the corner of the OLED pixel is processed to be rounded relates to the OLED characteristic emitting light itself, and thus the corner is essentially processed to be rounded.

Hereinafter, a laminated structure of the first light emitting group 100, the second emitting group 200, the third emitting group 300, and the fourth emitting group 400 will be described. Since all of the first light emitting group 100, the second emitting group 200, the third emitting group 300, and the fourth emitting group 400 has the same laminated structure, the first light emitting group 100 will be exemplarily described.

Each of the four first sub-pixels 100sp constituting the first light emitting group 100 has a laminated structure of a switching device, a pixel electrode 110 electrically connected to the switching device, a light emitting layer 120, and an opposite electrode 130, and a thin-film encapsulation layer in which an organic layer 150 and an inorganic layer 140 and 160 are mixed is formed on the opposite electrode 130.

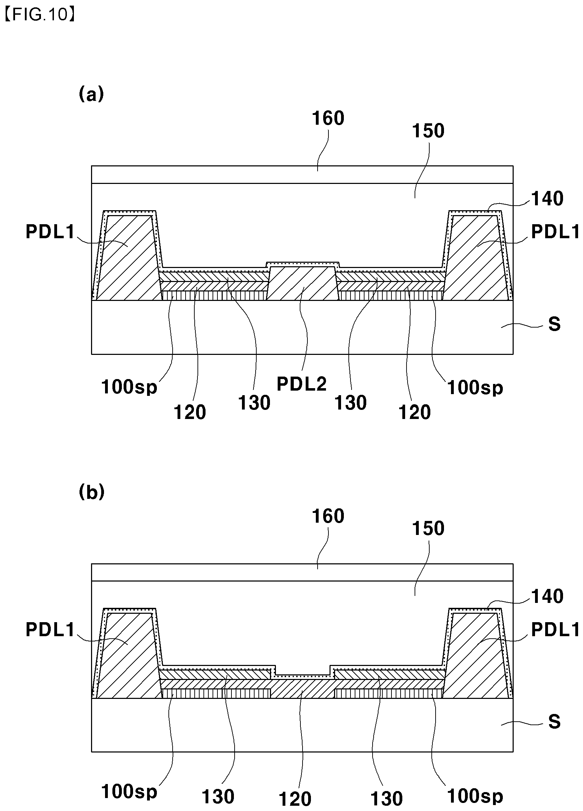

Specifically, as illustrated in (a) of FIG. 10, the first light emitting group 100 may include a thin-film transistor substrate S, four pixel electrodes 110 disposed on the thin-film transistor substrate S in correspondence to the four first sub-pixels 100sp, respectively, a light emitting group defining layer PDL1, a sub-pixel defining layer PDL2, four light emitting layers 120 laminated on the four pixel electrodes 110, respectively, and four opposite electrodes 130 laminated on the four light emitting layers 120, respectively. (a) of FIG. 10 is a cross-sectional view illustrating only two pixel electrodes 110, two light emitting layers 120, and two opposite electrodes 130.

The thin-film transistor substrate S may include a line layer and a plurality of thin-film transistors. For example, the line layer may include a plurality of gate lines and a plurality of data lines crossing the gate lines, and the thin-film transistors may be electrically connected to the gate lines and the data lines.

For example, the gate lines may each extend in the X-axis direction, and the data lines may each extend in the Y-axis direction.

The first sub-pixel 100sp, the second sub-pixel 200sp, the third sub-pixel 300sp, and the fourth sub-pixel 400sp, which constitute one pixel Px, may be electrically connected to the gate lines and the data lines, respectively.

As described above, as the third sub-pixel 300sp and the fourth sub-pixel 400sp, which constitute the display apparatus of the first embodiment, emit the same blue light, the third sub-pixel 300sp and the fourth sub-pixel 400sp may be electrically connected to share the gate line and the data line.

That is, the third sub-pixel 300sp and the fourth sub-pixel 400sp may be simultaneously controlled.

Alternatively, although the third sub-pixel 300sp and the fourth sub-pixel 400sp emit the same blue light, the third sub-pixel 300sp and the fourth sub-pixel 400sp may be individually controlled without sharing the gate lien and the data line.

The light emitting group defining layer PDL1 may be disposed on the thin-film transistor substrate, and an opening corresponding to the first light emitting group 100 may be formed therein. Four pixel electrodes 110 may be arranged with equal angles in the light emitting group defining layer PDL1.

The sub-pixel defining layer PDL2 may be further disposed in the light emitting group defining layer PDL1. The sub-pixel defining layer PDL2 may be disposed between the four pixel electrodes 110. The sub-pixel defining layer PDL2 may expose top surfaces of the four pixel electrodes 110.

The light emitting group defining layer PDL1 may be simultaneously formed with the sub-pixel defining layer PDL2 through the same process, or the light emitting group and the sub-pixel defining layer PDL2 may be formed as structures having different heights by applying materials having different properties through different processes. The light emitting group defining layer PDL1 may have a thickness higher than that of the sub-pixel defining layer PDL2.

When a top surface of the light emitting group pixel defining layer PDL1 has a high hydrophobic property and is formed through a different process by applying a material having a different property from the sub-pixel defining layer PDL2, a side surface of the light emitting group pixel defining layer PDL1 may have a higher hydrophilic property than applied ink.

When a top surface of the sub-pixel defining layer PDL2 has a lyophobic property and is formed through the same process by applying a material having the same property as the sub-pixel defining layer PDL2, a side surface of the sub-pixel defining layer PDL2 may have a lyophilic property, and a height of the sub-pixel defining layer PDL2 may be higher than a laminated height of the pixel electrode 110, the light emitting layer 120, and the opposite electrode 130.

Thus, when the light emitting layer 120 is formed by a method such as inkjet printing, an ink drop may be applied only within the light emitting group defining layer PDL1 due to a difference of surface tension of each surfaces, and also the light emitting layer 120 may be uniformly formed on the pixel electrode 110 between the sub-pixel defining layers PDL2.

The light emitting layer 120 may be laminated on each of the four pixel electrodes 110 in the opening of the light emitting group defining layer PDL1.

However, the material contained in the light emitting layer 120 is not particularly limited. The light emitting layer 120 may be formed by using organic light emitting materials capable of emitting a red, green, or blue wavelength by fluorescence or phosphorescence mechanism. Alternatively, a red, green, or blue resist material for forming the color filter layer may be used. Alternatively, ink including a red, green, or blue quantum dot or perovskite material for forming a color conversion layer may be used. Also, a red, green, or blue quantum dot or perovskite ink for a quantum dot or perovskite display apparatus may be used.

Specifically, the light emitting layer 120 may be formed by using inkjet printing, a nozzle printing method, organic vapor jet printing (OVJP), or organic vapor phase deposition (OVPD).

For example, the light emitting layer 120 may be selectively applied by a drop deposition or inkjet printing method. As one specific example, the light emitting layer 120 formed in the first light emitting group 100, the light emitting layer 120 formed in the second light emitting group 200, the light emitting layer 120 formed in the third light emitting group 300, and the light emitting layer 120 formed in the fourth light emitting group 400 may be simultaneously or individually formed by the inkjet printing.

Here, when all of the light emitting layer 120 formed in the first light emitting group 100, the light emitting layer 120 formed in the second light emitting group 200, the light emitting layer 120 formed in the third light emitting group 300, and the light emitting layer 120 formed in the fourth light emitting group 400 emit different color light, each of the light emitting layers 120 may be formed with different inks by the inkjet printing.

Also, when the light emitting layer 120 formed in the first light emitting group 100, the light emitting layer 120 formed in the second light emitting group 200, the light emitting layer 120 formed in the third light emitting group 300, and the light emitting layer 120 formed in the fourth light emitting group 400 emit the same color light, the light emitting layer 120 formed in the third light emitting group 300 and the light emitting layer 120 formed in the fourth light emitting group 400 may be formed with the same ink by the inkjet printing.

According to this embodiment, since the first light emitting group 100 may include the four light emitting parts contained in the four pixels Px, respectively, and the light emitting parts, i.e., the sub-pixles Px, having a four times greater resolution than a resolution may be constituted when the light emitting layer 120 of the first light emitting group 100 is printed, the display apparatus having a higher resolution than a printing resolution of the light emitting layer 120 may be realized.

The opposite electrode 130 may be laminated on each of the four light emitting layers in the opening of the light emitting group defining layer PDL1.

The thin-film encapsulation layer may prevent external moisture and oxygen from being permeated and include at least one organic layer 150 and at least one inorganic layer 140 and 160, and the organic layer 150 and the inorganic layer 140 and 160 may be alternately laminated with each other.

For example, although the thin-film encapsulation layer may be constituted by sequentially laminating a first inorganic layer 140, an organic layer 150, and a second inorganic layer 160, the embodiment of the present invention is not limited thereto. In another embodiment, a sealing substrate for blocking atmosphere and moisture from being permeated into the display apparatus may be provided instead of the thin-film encapsulation layer.

The above-described laminated structure of the first light emitting group 100 may be applied to the second light emitting group 200, the third light emitting group 300, and the fourth light emitting group 400 in the same manner.

Meanwhile, as another laminated structure of the first light emitting group 100, as illustrated in (b) of FIG. 10, the first light emitting group 100 may include four pixel electrodes 110 corresponding to the four sub-pixels Px, respectively, one light emitting layer 120 overlapping all of the four pixel electrodes 110, and four opposite electrodes 130 laminated on the light emitting layers 120 in correspondence to the four pixel electrodes 110, respectively. Although the light emitting layers 120 are connected into one body to overlap all of the four pixel electrodes 110 in a structure of (b) of FIG. 19, other portions are the same as each other.

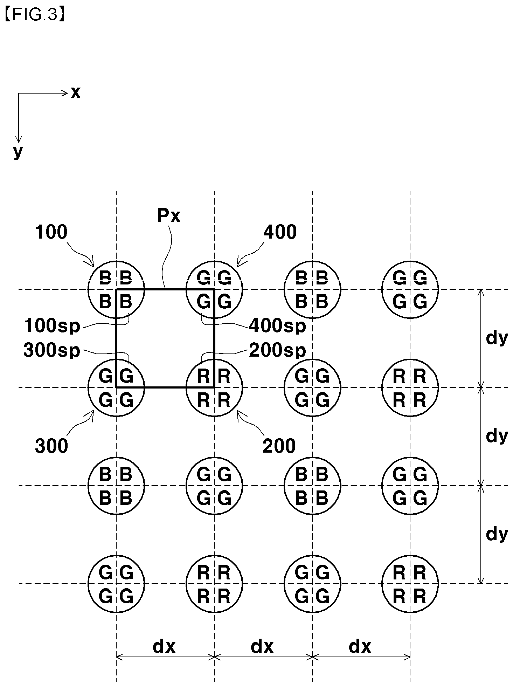

Hereinafter, a display apparatus according to a second embodiment of the present invention will be described with reference to FIG. 3.

As illustrated in FIG. 3, the display apparatus according to the second embodiment includes a first light emitting group 100 including four first sub-pixels 100sp, a second light emitting group 200 including four second sub-pixels 200sp, a third light emitting group 300 including four third sub-pixels 300sp, and a fourth light emitting group 400 including four fourth sub-pixels 400sp.

The display apparatus according to the second embodiment is substantially the same as the display apparatus according to the first embodiment except for colors emitted by the first light emitting group 100, the second light emitting group 200, the third light emitting group 300, and the fourth light emitting group 400, and a repeated description thereof will be omitted.

The four first sub-pixels 100sp constituting the first light emitting group 100 constituting the display apparatus according to the second embodiment emit blue light, the four second sub-pixels 200sp constituting the second light emitting group 200 emit red light, the four third sub-pixels 300sp constituting the third light emitting group 300 emit green light, and the four fourth sub-pixels 400sp constituting the fourth light emitting group 400 emit green light.

Four sub-pixels Px, i.e., the first sub-pixel 100sp emitting blue light, the second sub-pixel 200sp emitting red light, the third sub-pixel 300sp emitting green light, and the fourth sub-pixel 400sp emitting green light, which are disposed closest to each other, form one pixel Px by the above-described constitution of the first light emitting group 100, the second light emitting group 200, the third light emitting group 300, and the fourth light emitting group 400.

As described above, as the first sub-pixel 100sp emitting the blue light, the second sub-pixel 200sp emitting the red light, the third sub-pixel 300sp emitting the green light, and the fourth sub-pixel 400sp emitting the green light are gathered to constitute one pixel Px, a structure in which the green light is emitted from an area corresponding two times of a light emitting area of the blue light or the red light may be formed.

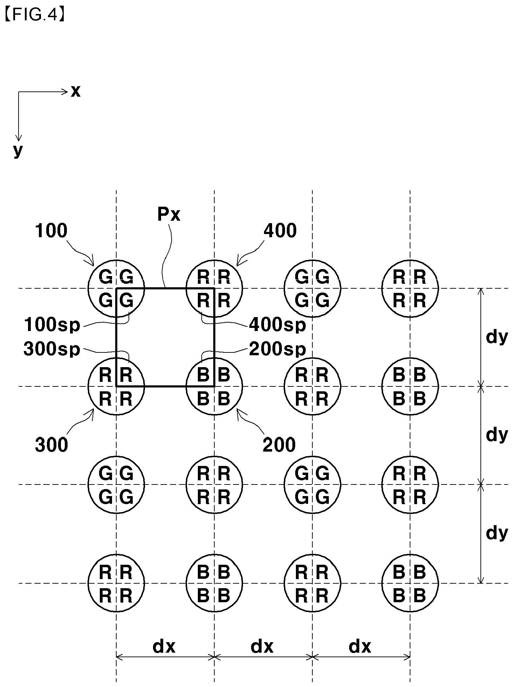

Hereinafter, a display apparatus according to a third embodiment of the present invention will be described with reference to FIG. 4.

As illustrated in FIG. 4, the display apparatus according to the third embodiment includes a first light emitting group 100 including four first sub-pixels 100sp, a second light emitting group 200 including four second sub-pixels 200sp, a third light emitting group 300 including four third sub-pixels 300sp, and a fourth light emitting group 400 including four fourth sub-pixels 400sp.

The display apparatus according to the third embodiment is substantially the same as the display apparatus according to the first embodiment except for colors emitted by the first light emitting group 100, the second light emitting group 200, the third light emitting group 300, and the fourth light emitting group 400, and a repeated description thereof will be omitted.

The four first sub-pixels 100sp constituting the first light emitting group 100 constituting the display apparatus according to the third embodiment emit green light, the four second sub-pixels 200sp constituting the second light emitting group 200 emit blue light, the four third sub-pixels 300sp constituting the third light emitting group 300 emit red light, and the four fourth sub-pixels 400sp constituting the fourth light emitting group 400 emit red light.

Four sub-pixels Px, i.e., the first sub-pixel 100sp emitting green light, the second sub-pixel 200sp emitting blue light, the third sub-pixel 300sp emitting red light, and the fourth sub-pixel 400sp emitting red light, which are disposed closest to each other, form one pixel Px by the above-described constitution of the first light emitting group 100, the second light emitting group 200, the third light emitting group 300, and the fourth light emitting group 400.

As described above, as the first sub-pixel 100sp emitting the green light, the second sub-pixel 200sp emitting the blue light, the third sub-pixel 300sp emitting the red light, and the fourth sub-pixel 400sp emitting the red light are gathered to constitute one pixel Px, a structure in which the red light is emitted from an area corresponding two times of a light emitting area of the green light or the blue light may be formed.

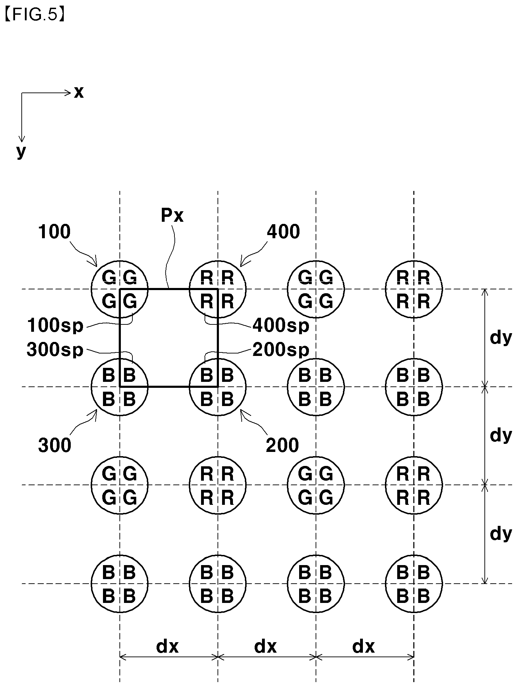

Hereinafter, a display apparatus according to a fourth embodiment of the present invention will be described with reference to FIG. 5.

As illustrated in FIG. 5, the display apparatus according to the fourth embodiment includes a first light emitting group 100 including four first sub-pixels 100sp, a second light emitting group 200 including four second sub-pixels 200sp, a third light emitting group 300 including four third sub-pixels 300sp, and a fourth light emitting group 400 including four fourth sub-pixels 400sp.

The display apparatus according to the fourth embodiment is substantially the same as the display apparatus according to the first embodiment except for colors emitted by the first light emitting group 100, the second light emitting group 200, the third light emitting group 300, and the fourth light emitting group 400, and a repeated description thereof will be omitted.

The four first sub-pixels 100sp constituting the first light emitting group 100 constituting the display apparatus according to the fourth embodiment emit green light, the four second sub-pixels 200sp constituting the second light emitting group 200 emit blue light, the four third sub-pixels 300sp constituting the third light emitting group 300 emit blue light, and the four fourth sub-pixels 400sp constituting the fourth light emitting group 400 emit red light.

Four sub-pixels Px, i.e., the first sub-pixel 100sp emitting green light, the second sub-pixel 200sp emitting blue light, the third sub-pixel 300sp emitting blue light, and the fourth sub-pixel 400sp emitting red light, which are disposed closest to each other, form one pixel Px by the above-described constitution of the first light emitting group 100, the second light emitting group 200, the third light emitting group 300, and the fourth light emitting group 400.

As described above, as the first sub-pixel 100sp emitting the green light, the second sub-pixel 200sp emitting the blue light, the third sub-pixel 300sp emitting the blue light, and the fourth sub-pixel 400sp emitting the red light are gathered to constitute one pixel Px, a structure in which the blue light is emitted from an area corresponding two times of a light emitting area of the green light or the red light may be formed. Through the above constitution, a disadvantage, in which a blue device that is an organic light emitting material emitting blue light having a low efficiency generally has a shorter lifespan than an organic light emitting material emitting different color light, may be compensated.

Particularly, as illustrated in FIG. 5, as the display apparatus according to the fourth embodiment is constituted such that the second sub-pixel 200sp and the third sub-pixel 300sp emit the same blue light, the sub-pixels Px emitting the blue light are arranged in a row along the X-axis direction.

As described above, as the sub-pixels Px emitting the blue light are arranged in a row along the X-axis direction, when manufactured by the inkjet method, there is an advantage in that the number of lines of blue ink to be printed is reduced into a half to further easily perform an inkjet process and increase an overall inkjet printing speed by two times.

As described above, as the third sub-pixel 300sp and the fourth sub-pixel 400sp, which constitute the display apparatus of the fourth embodiment, are arranged in a row to emit the same blue light, the third sub-pixel 300sp and the fourth sub-pixel 400sp may be electrically connected to share the gate line and the data line and controlled at the same time.

Alternatively, although the third sub-pixel 300sp and the fourth sub-pixel 400sp emit the same blue light, the third sub-pixel 300sp and the fourth sub-pixel 400sp may be individually controlled without sharing the gate lien and the data line.

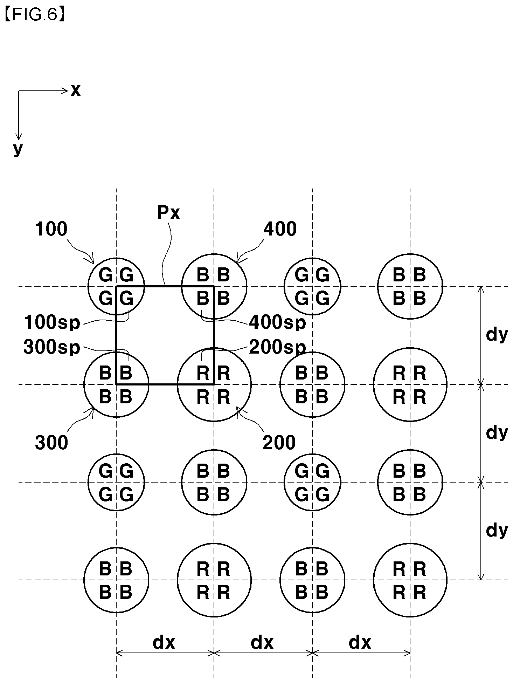

Hereinafter, a display apparatus according to a fifth embodiment of the present invention will be described with reference to FIG. 6.

As illustrated in FIG. 6, the display apparatus according to the fifth embodiment includes a first light emitting group 100 including four first sub-pixels 100sp, a second light emitting group 200 including four second sub-pixels 200sp, a third light emitting group 300 including four third sub-pixels 300sp, and a fourth light emitting group 400 including four fourth sub-pixels 400sp.

The display apparatus according to the fifth embodiment is substantially the same as the display apparatus according to the first embodiment except for areas of the first light emitting group 100, the second light emitting group 200, the third light emitting group 300, and the fourth light emitting group 400, and a repeated description thereof will be omitted.

The four first sub-pixels 100sp constituting the first light emitting group 100 constituting the display apparatus according to the fifth embodiment emit green light, the four second sub-pixels 200sp constituting the second light emitting group 200 emit red light, the four third sub-pixels 300sp constituting the third light emitting group 300 emit blue light, and the four fourth sub-pixels 400sp constituting the fourth light emitting group 400 emit blue light.

Meanwhile, in order to optimize a color and brightness of the display apparatus 10, the third sub-pixels 300sp and the fourth sub-pixels 400sp may have the same area, the first sub-pixels 100sp may have an area less than that of each of the third sub-pixels 300sp and the fourth sub-pixels 400sp, and the second sub-pixels 200sp may have an area greater than that of each of the third sub-pixels 300sp and the fourth sub-pixels 400sp.

When described in a different viewpoint, overall uniformity of color light may improve such that the blue light having a low efficiency is emitted from the third light emitting group 300 and the fourth light emitting group 400 to have the number per unit area, which is greater by two times than a light emitting area of different color light, a size of the first light emitting group 100 emitting the green light having a high efficiency further decreases, and a size of the second light emitting group 200 emitting an intermediate efficiency further increases.

The area and color of each of the first light emitting group 100, the second light emitting group 200, the third light emitting group 300, and the fourth light emitting group 400 may be appropriately changed according to the efficiency of the red, green, and blue light.

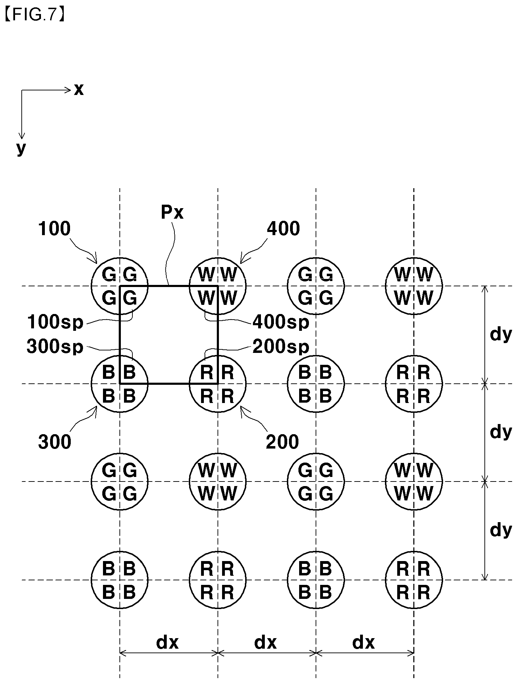

Hereinafter, a display apparatus according to a sixth embodiment of the present invention will be described with reference to FIG. 7.

As illustrated in FIG. 7, the display apparatus according to the sixth embodiment includes a first light emitting group 100 including four first sub-pixels 100sp, a second light emitting group 200 including four second sub-pixels 200sp, a third light emitting group 300 including four third sub-pixels 300sp, and a fourth light emitting group 400 including four fourth sub-pixels 400sp.

The display apparatus according to the sixth embodiment is substantially the same as the display apparatus according to the first embodiment except for colors emitted by the first light emitting group 100, the second light emitting group 200, the third light emitting group 300, and the fourth light emitting group 400, and a repeated description thereof will be omitted.

The four first sub-pixels 100sp constituting the first light emitting group 100 constituting the display apparatus according to the sixth embodiment emit green light, the four second sub-pixels 200sp constituting the second light emitting group 200 emit red light, the four third sub-pixels 300sp constituting the third light emitting group 300 emit blue light, and the four fourth sub-pixels 400sp constituting the fourth light emitting group 400 emit white light.

Four sub-pixels Px, i.e., the first sub-pixel 100sp emitting green light, the second sub-pixel 200sp emitting red light, the third sub-pixel 300sp emitting blue light, and the fourth sub-pixel 400sp emitting white light, which are disposed closest to each other, form one pixel Px by the above-described constitution of the first light emitting group 100, the second light emitting group 200, the third light emitting group 300, and the fourth light emitting group 400.

As described above, as the first sub-pixel 100sp emitting the green light, the second sub-pixel 200sp emitting the red light, the third sub-pixel 300sp emitting the blue light, and the fourth sub-pixel 400sp emitting the white light are gathered to constitute one pixel Px, entire brightness of the display apparatus may improve. That is, the entire brightness of the display apparatus may improve by the white light.

The above-described display apparatus according to the embodiment of the present invention may be formed through the inkjet printing method, and the above-described inkjet printing technology may be applied to a field requiring the high resolution RGB pixel printing process in addition to the high resolution OLED display apparatus described in the above embodiment.

For example, the inkjet printing technology may be applied in printing of a color filter, a quantum dot color conversion (QDCC) layer, a perovskite color conversion layer, a self-light emitting RGB QD (OLED) display apparatus, which belongs to the RGB pixel printing field.

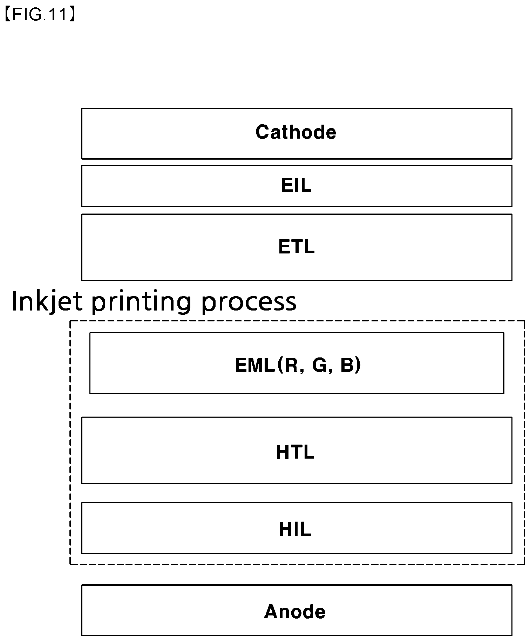

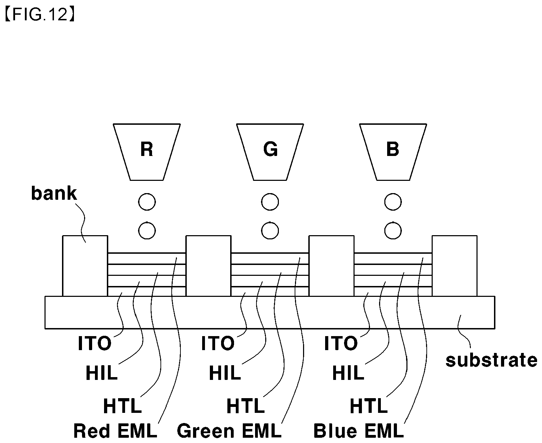

Also, as illustrated in FIGS. 11 and 12, in case of a polymer OLED display apparatus manufactured by printing three layers by inkjet, the inkjet printing technology may be applied in printing of RGB pixels Px using a polymer RGB EML material, a hole injection layer (HIL), and an interlayer (IL).

Also, in case of a future stretchable OLED having extremely high elasticity, since even a thin-film encapsulation (TFE) having elasticity is realized by a unit of the pixel Px, printing may be performed in a unit of the high resolution pixel Px. Due to this reason, the inkjet printing technology may be applied in printing of the organic thin-film encapsulation layer of the high resolution RGB pixel Px using single organic ink.

Also, even in a quantum dot nano-LED display apparatus, a nano-LED may be put into the ink to perform the inkjet printing, and this ink may be applied in printing of the pixel Px having a high resolution of 400 PPI or more. The display apparatus constituted by only blue nano-LED requires printing of a color filter layer and a quantum dot color converter (QDCC) layer in order to convert blue light into green light and red light, and the inkjet printing technology may be also applied in this case.

Also, when effective red and green nano-LEDs are developed in addition to the blue nano-LED, the self-light emitting QNED display apparatus may be realized, and the blue, red, and green nano-LEDs may be put into each ink to perform the inkjet printing. The high resolution QNED RGB pixel Px may be printed to be realized as each nano LED pixel PX, and aligned to electrodes in an electrophoretic method to realize the RGB pixel electrode 110.

Also, the inkjet printing technology may be applied in printing of a color filter layer, a quantum dot color conversion (QDCC) layer, or a perovskite color conversion (PCC) layer for a micro-LED display apparatus, and particularly, in manufacturing of a color filter, a quantum dot color conversion layer, or a perovskite color conversion layer for manufacturing a micro-LED or a micro-OLED for virtual reality (VR), augmented reality (AR), mixed reality (MR), and extended reality (XR).

Also, the inkjet printing may be applied in forming of a thin-film transistor layer requiring exact position and size and high resolution by a printing method of printing four thin-film transistors through one printing with the same concept.

While the present invention has been particularly shown and described with reference to the accompanying drawings according to exemplary embodiments, it will be understood by those of ordinary skill in the art that various changes in form and details may be made therein without departing from the spirit and scope of the present invention as defined by the following claims. Thus, it is intended that the present invention covers the modifications and variations of this invention provided they come within the scope of the appended claims and their equivalents.

### [Description of reference numerals]

| | | | |
|---|---|---|---|
| 100: | First light emitting group | 100sp: | First sub-pixel |
| 200: | Second light emitting group | 200sp: | Second sub-pixel |
| 300: | Third light emitting group | 300sp: | Third sub-pixel |
| 400: | Fourth light emitting group | 400sp: | Fourth sub-pixel |
| 110: | Pixel electrode | 120: | Light emitting layer |
| 130: | Opposite electrode | 140: | First inorganic layer |
| 150: | Organic layer | 160: | Second inorganic layer |
| PDL1: | Light emitting group defining layer | PDL2: | Sub-pixel defining layer |
| Px: | Pixel | | |

## Claims

1. A display apparatus comprising
a first light emitting group comprising four first sub-pixels contained in different pixels to emit the same color light;
a second light emitting group comprising four second sub-pixels contained in different pixels to emit the same color light;
a third light emitting group comprising four third sub-pixels contained in different pixels to emit the same color light; and
a fourth light emitting group comprising four fourth sub-pixels contained in different pixels to emit the same color light,
wherein four of the first sub-pixel, the second sub-pixel, the third sub-pixel, and the fourth sub-pixel, which are disposed closest to each other, form one pixel.

2. The display apparatus of claim 1, wherein each of the first to fourth light emitting groups is formed in plurality and arranged in a matrix form on a thin-film transistor substrate along a first direction and a second direction crossing the first direction, and
the number of each of the first to fourth light emitting groups is equal to each other.

3. The display apparatus of claim 2, wherein the first to fourth light emitting groups are spaced by the same gap from each other,
centers of two neighboring light emitting groups among the first to fourth light emitting groups are spaced by a first distance, and
the closest same light emitting groups is spaced by a second distance that is two times of the first distance.

4. The display apparatus of claim 3, wherein the first to fourth sub-pixels constituting the one pixel are arranged in a rectangular shape.

5. The display apparatus of claim 4, wherein each of the first to fourth sub-pixels has a central angle of 90°, and a corner formed is processed to be rounded.

6. The display apparatus of claim 1, wherein each of the first to fourth light emitting groups emits one color light of red, green, blue, and white light, and
the first to fourth light emitting groups emit different color light.

7. The display apparatus of claim 1, wherein each of the first to fourth light emitting groups emits one color light of red, green, blue, and white light, and
two light emitting groups among the first to fourth light emitting groups emit the same color light.

8. The display apparatus of claim 7, wherein the two light emitting groups emitting the same color light are electrically connected with the same thin-film transistor and simultaneously controlled.

9. The display apparatus of claim 7, wherein the two light emitting groups emitting the same color light are electrically connected with different thin-film transistors and individually controlled.

10. The display apparatus of claim 7, wherein the two light emitting groups emitting the same color light emit blue light, one light emitting group of the rest emits red light, and the other light emitting group of the rest emits green light.

11. The display apparatus of claim 7, wherein the two light emitting groups emitting the same color light emit green light, one light emitting group of the rest emits red light, and the other light emitting group of the rest emits blue light.

12. The display apparatus of claim 7, wherein the two light emitting groups emitting the same color light emit red light, one light emitting group of the rest emits green light, and the other light emitting group of the rest emits blue light.

13. The display apparatus of claim 1, wherein each of the first to fourth light emitting groups comprises: four pixel electrodes corresponding to four sub-pixels, respectively; four light emitting layers laminated on the four pixel electrodes, respectively; and four opposite electrodes laminated on the four light emitting layers, respectively.

14. The display apparatus of claim 1, wherein each of the first to fourth light emitting groups comprises: four pixel electrodes corresponding to four sub-pixels, respectively; one light emitting layer overlapping all of the four pixel electrodes; and four opposite electrodes laminated on the light emitting layer in correspondence to the four pixel electrodes, respectively.

15. The display apparatus of claim 13 or 14, wherein each of a light emitting layer formed in the first light emitting group, a light emitting layer formed in the second light emitting group, a light emitting layer formed in the third light emitting group, and a light emitting layer formed in the fourth light emitting group is formed with a different ink by inkjet printing.

16. The display apparatus of claim 13 or 14, wherein a light emitting layer formed in the first light emitting group, a light emitting layer formed in the second light emitting group, a light emitting layer formed in the third light emitting group, and a light emitting layer formed in the fourth light emitting group are formed by inkjet printing, and
at least two light emitting layers of the light emitting layer formed in the first light emitting group, the light emitting layer formed in the second light emitting group, the light emitting layer formed in the third light emitting group, and the light emitting layer formed in the fourth light emitting group are formed with the same ink by the inkjet printing.

17. The display apparatus of claim 1, wherein at least one light emitting group of the first light emitting group, the second light emitting group, the third light emitting group, and the fourth light emitting group has a different size.

18. The display apparatus of claim 7, wherein the two light emitting groups emitting the same color light are arranged on a thin-film transistor substrate in one row along a first direction or a second direction crossing the first direction.
